# EUROPÄISCHE PATENTANMELDUNG

(11) **EP 2 120 055 A2**
(43) Veröffentlichungstag der Anmeldung: **18.11.2009**
(21) Anmeldenummer: 09006579.8
(22) Anmeldetag: 15.05.2009
(51) Int. Cl.: G01R 11/04, H02B 1/03

(54) **Anschlusssystem für einen elektronischen Stromzähler**

(30) Priorität: 16.05.2008 DE 102008023971
(71) Anmelder: Hager Electro GmbH & Co. KG, 66131 Saarbrücken (DE)
(72) Erfinder: Kelaiditis, Konstantin, Dr.-Ing., 66386 St. Ingbert (DE); Zimmermann, Michael, 66399 Mandelbachtal (DE)
(74) Vertreter: Bernhardt, Reinold

(57) **Zusammenfassung**

Die Erfindung betrifft ein Anschlusssystem für einen elektronischen Stromzähler, mit einem Anschlussmodul, an den der Stromzähler in einer Aufsteck- und Verschiebebewegung elektrisch und mechanisch koppelbar ist und der ein Gehäuse (2) mit einer außenseitigen Tragfläche (3) für den Stromzähler aufweist, in der Öffnungen (4) für die Einführung vom Stromzähler in Aufsteckrichtung vorstehender Anschlusskontakte in das Gehäuse (2) gebildet und wobei in dem Gehäuse Elemente zum lösbaren Anschluss Strom führender Leitungen untergebracht sind. Das Anschlusssystem nach der Erfindung ist **dadurch gekennzeichnet, dass** das Gehäuse des Anschlussmoduls die Grundform einer rechteckigen Platte aufweist und dass an einer der schmalen Randseiten des Gehäuses Elemente für den Anschluss ungezählten Strom führender Leitungen und an der anderen schmalen Randseite Elemente für den Anschluss gezählten Strom führender Leitungen angeordnet sind.

## Beschreibung

Die Erfindung betrifft ein Anschlusssystem für einen elektronischen Stromzähler, mit einem Anschlussmodul, an den der Stromzähler in einer Aufsteck- und Verschiebebewegung elektrisch und mechanisch koppelbar ist und der ein Gehäuse mit einer außenseitigen Tragfläche für den Stromzähler aufweist, in der Öffnungen zur Einführung von dem Stromzähler in Aufsteckrichtung vorstehender Anschlusskontakte in das Gehäuse gebildet und wobei in dem Gehäuse Elemente zum lösbaren Anschluss Strom führender Leitungen untergebracht sind.

Ein Anschlusssystem für einen elektronischen Stromzähler mit einem Anschlussmodul der vorangehend beschriebenen Art ist aus der DE 102 61 206 A1 bekannt. Sämtliche Anschlusselemente dieses bekannten Moduls sind in einem leistenförmigen Abschnitt des Gehäuses untergebracht, welcher sich unter Bildung einer T-Form an einen quaderförmigen, den Stromzähler aufnehmenden Abschnitt des Gehäuses anschließt. Der Anschlussleistenabschnitt lässt sich am horizontalen Schenkel des Zählerkreuzes eines herkömmlichen Zählerplatzes anbringen, während der quaderförmige Gehäuseteil mit einem vertikalen Schenkel des Zählerkreuzes verbunden wird.

Der Erfindung liegt die Aufgabe zugrunde, ein neues Anschlusssystem mit einem Anschlussmodul zu schaffen, der sich variabler als der bekannte Anschlussmodul einsetzen lässt.

Das diese Aufgabe lösende Anschlusssystem nach der Erfindung ist **dadurch gekennzeichnet, dass** das Gehäuse des Anschlussmoduls die Grundform einer rechteckigen Platte aufweist und dass an einer der schmalen Randseiten des Gehäuses Elemente für den Anschluss ungezählten Strom führender Leitungen und an der anderen schmalen Randseite Elemente für den Anschluss gezählten Strom führender Leitungen angeordnet sind.

Durch die erfindungsgemäße Verteilung der Anschlusselemente auf die beiden schmalen Randseiten des Gehäuses lässt sich vorteilhaft die Baubreite des Anschlussmoduls verringern. So können z.B. auf der Tragplatte eines herkömmlichen Zählerplatzes bei Bedarf zwei solcher Module nebeneinander montiert werden.

Vorteilhaft sind auf beiden schmalen Randseiten ferner Elemente für den Anschluss von Spannungsversorgungsleitungen für elektronische Zusatzgeräte, wie sie an Zählerplätzen zunehmend zum Einsatz kommen, vorgesehen. Vom Stromversorgungsunternehmen betriebene Zusatzgeräte werden dann durch ungezählten Strom gespeist, während vom Stromkunden betriebene Zusatzgeräte mit den Anschlusselementen an der anderen Schmalseite des Anschlussmoduls verbunden sind.

Bei den Anschlusselementen handelt es sich vorzugsweise um Klemmanschlusselemente, insbesondere Schraubklemmanschlusselemente.

Zweckmäßig sind die Anschlusselemente unter Bildung von Anschlussleisten in zu den Randseiten parallelen Reihen angeordnet, wobei die Länge der Anschlussleisten die Länge der schmalen Randseiten nicht überschreitet.

In einer bevorzugten Ausführungsform der Erfindung sind auf gegenüberliegenden Randseiten des Gehäuses, insbesondere den Längsseiten, Rastnasen zur Rastverbindung des Anschlussmoduls mit einer den Anschlussmodul tragenden Aufnahmeeinrichtung vorgesehen.

An dem Gehäuse können ferner Einrichtungen zur Befestigung des Anschlussmoduls am Zählerkreuz eines herkömmlichen Zählerplatzes gebildet sein, wobei diese Einrichtungen vorzugsweise einen Durchgang durch das Gehäuse und zwei, insbesondere an Gehäuseecken vorstehende, Hakenelemente umfasst. Die Hakenelemente lassen sich in den horizontalen Schenkel des Zählerkreuzes einhängen, während durch den Durchgang ein Drehbolzenelement mit einer seitlich vorstehenden, die vertikale Schiene des Zählerkreuzes hintergreifenden Nase einführbar ist.

Bei der Aufnahmeeinrichtung kann es sich um eine Aufnahmeeinrichtung handeln, wie sie aus der DE 10 2005 021 136 A1 hervorgeht, wobei diese Aufnahmeeinrichtung eine die anschließbaren Leitungen abdeckende Platte aufweist, in der zwei Öffnungen in die je ein Anschlussmodul 1 einsetzbar ist, gebildet sind.

Zweckmäßig greifen die oben genannten Rastnasen in Öffnungen ein, die in Stegen gebildet sind, die an Rändern der Öffnungen, insbesondere Längsrändern von der genannten Platte vorstehen.

Beim Einsetzen des Anschlussmoduls in die Öffnung müssen Öffnungsabschnitte, die an die obere und untere Schmalseite angrenzen, frei bleiben, um die Montagefreiheit für Verbindung der genannten Leitungen mit den Anschlusselementen zu schaffen. In einer Ausführungsform der Erfindung sind Deckel vorgesehen, durch die diese Öffnungen dann verschließbar sind.

Die Deckel können zur Befestigung an der Aufnahmeeinrichtung und dem Anschlussmodul an dem Anschlussmodul oder/und der Aufnahmeeinrichtung einrastbar sein.

In einer bevorzugten Ausführungsform weist der Deckel für die schmale Randseite, an der die Anschlusselemente für die ungezählten Strom führenden Leitungen angeordnet sind, eine in der Anschlussposition des Stromzählers den Stromzähler hintergreifende Nase auf. So lässt sich der Deckel in seiner Verschlussposition durch Formschluss sichern.

Zusätzlich können Einrichtungen für eine plombierbare Schraubbefestigung der Deckel vorgesehen sein.

In einer weiteren Ausführungsform der Erfindung sind am Gehäuse seitliche Öffnungen für den Eingriff den Anschlussmodul auf einer ebenen Trägerplatte haltender Befestigungslaschen vorgesehen.

In weiterer Ausgestaltung der Erfindung ist ein um die Trägerfläche umlaufender, vor Zugriffen auf die Anschlusskontakte des Stromzählers schützender Randsteg gebildet.

Angrenzend an den Randsteg können Rillen für den Eingriff an den Deckeln in ihrer Verschlussposition gebildeter Abwinklungen vorgesehen sein, die der Halterung der Deckel durch Formschluss dienen.

In einer Ausführungsform der Erfindung weist der Modul ein abnehmbares und in umgekehrter Lage wieder an dem Anschlussmodul anbringbares Anzeigeschild auf, das z.B. anzeigt, ob die Anlage mit maximal 100 A oder nur maximal 63 A zu betreiben ist.

Die Erfindung wird nachfolgend anhand von Ausführungsbeispielen und der beiliegenden, sich auf diese Ausführungsbeispiele beziehenden Zeichnungen weiter erläutert. Es zeigen:
- Fig. 1: ein Ausführungsbeispiel für einen Anschlussmodul eines Anschluss-systems nach der Erfindung,
- Fig. 2: den Anschlussmodul von Fig. 1 eingebaut in eine Aufnahmevorrichtung,
- Fig. 3: die Ansicht von Fig. 2 mit zusätzlichen Verschlussdeckeln.
- Fig. 4: eine Längsschnittansicht des Anschlusssystems von Fig. 2 und 3,
- Fig. 5 und 6: Details der Ansicht von Fig. 4, und
- Fig. 7: den Anschlussmodul von Fig. 1 in Teildarstellung montiert auf einer Trägerplatte.

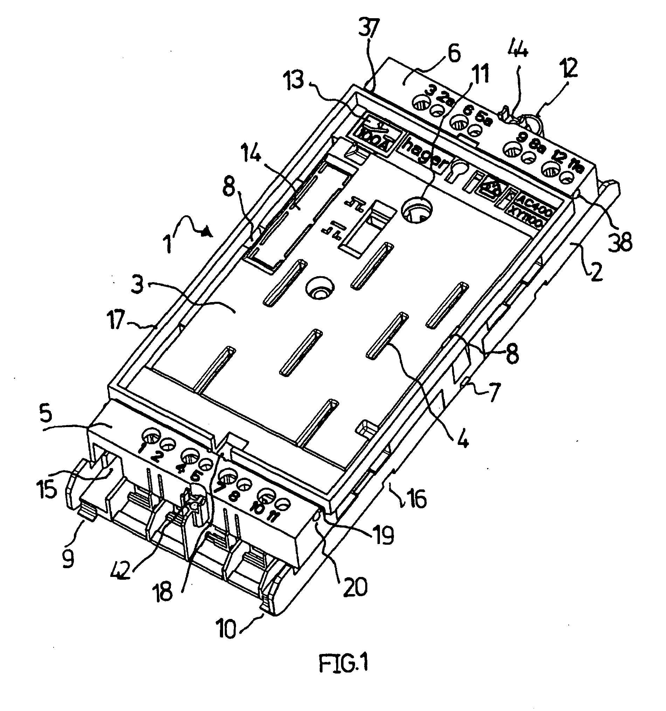

Ein in Fig. 1 dargestellter Anschlussmodul 1 eines Anschlusssystems für einen elektronischen Stromzähler (nicht gezeigt) umfasst ein in seiner Grundform an eine Rechteckplatte angenähertes Kunststoffgehäuse 2 mit einer den Stromzähler aufnehmenden Tragfläche auf der Gehäuseaußenseite 3. In Schlitzöffnungen 4 in der durch eine Platte gebildeten Tragfläche 3 lassen sich vom Stromzählergehäuse vorstehende Kontaktmesser einführen und der Stromzähler dann unter Verbindung mit entsprechenden Anschlusskontakten innerhalb des Gehäuses parallel zur Tragfläche 3 in eine Anschlussposition verschieben.

Sowohl an der unteren als auch an der oberen schmalen Randseite des Gehäuses 2 ist jeweils eine Anschlussleiste 5 bzw. 6 mit jeweils acht Schraubklemmanschlusselementen gebildet. An vier der Schraubklemmanschlusselemente der Anschlussleisten 5,6 lassen sich jeweils drei Strom führende Phasenleitungen sowie ein Neutralleiterkabel anschließen. Mit den Anschlusselementen für die Phasenleitungen und das Neutralleiterkabel sind Klemmanschlusselemente zum Abgreifen von Versorgungsspannungen verbunden. An der Anschlussleiste 5 fließt ungezählter Strom in den Anschlussmodul. Über die Anschlussleiste 6 fließt gezählter Strom.

An dem Gehäuse 2 sind an dessen Längsseiten einander gegenüberliegend Rastnasen 7 zur Rastverbindung mit einer in den nachfolgenden Figuren dargestellten Aufnahmeeinrichtung 21 für den Anschlussmodul 1 vorgesehen. Zwecks Lösen des Anschlussmoduls von der Aufnahmeeinrichtung 21 sind die Rastnasen 7 über Durchgänge 8, die zur Tragfläche 3 hin öffnen, zugänglich.

Das Gehäuse 2 weist ferner Einrichtungen zur Befestigung an einem herkömmlichen Zählerkreuz auf. Diese Einrichtungen umfassen an den unteren Kastenecken angeordnete Hakenelemente 9 und 10, sowie einen Durchgang 11 durch das Gehäuse 2. Über die Hakenelemente 9 und 10 lässt sich der Anschlussmodul 1 am horizontalen Schenkel des Zählerkreuzes einhaken. Der Durchgang 11 kann einen in die vertikale Schiene des Zählerkreuzes eingreifenden Drehbolzen (nicht gezeigt) mit einer seitlich vorstehenden, die Schiene hintergreifenden Nase aufweisen. Wahlweise kann zur Befestigung am vertikalen Schenkel des Zählerkreuzes auch eine an der oberen Randseite des Gehäuses 2 angebrachte Öse 12 verwendet werden.

Das Bezugszeichen 13 verweist auf ein Anzeigeschild, das von dem Anschlussmodul 1 lösbar ist und sich in umgekehrter Stellung wieder daran einrasten lässt.

Aus der die Tragfläche 3 bildenden Platte lässt sich unter Bildung eines Fensters ein Teilstück 14 ausbrechen. In dem gezeigten Ausführungsbeispiel kann hinter dem Fenster ein Optokoppler umfassender Verbindungsmodul für Signalkabel angeordnet werden, dem über einen bei 15 öffnenden Kabelkanal Signalleitungen zuführbar sind.

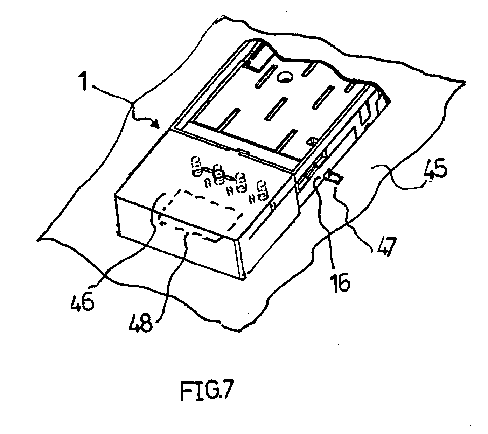

Vier, an den Längsseiten des Gehäuses 2 vorgesehene Öffnungen 16 lassen sich zur Befestigung des Anschlussmodul 1 auf einer Trägerplatte (Fig. 7) verwenden, wobei in die Öffnungen 16 mit der Trägerplatte verbundene Laschenteile 47 eingreifen.

Wie Fig. 1 ferner erkennen lässt, steht von der Tragfläche 3 des Anschlussmoduls 1 ein umlaufender Randsteg 17 vor, der an der unteren Anschlussleiste 5 bei 18 unterbrochen ist.

Zwischen dem Randsteg 17 und der Anschlussleiste 5 ist eine Rille 19 gebildet. Nahe der Rille 19 steht an beiden Enden der Anschlussleiste 5 eine Rastnase 20 vor. Eine solche Rille 37 und Rastnasen 38 befinden sich auch auf der gegenüberliegenden Seite der Tragfläche 3.

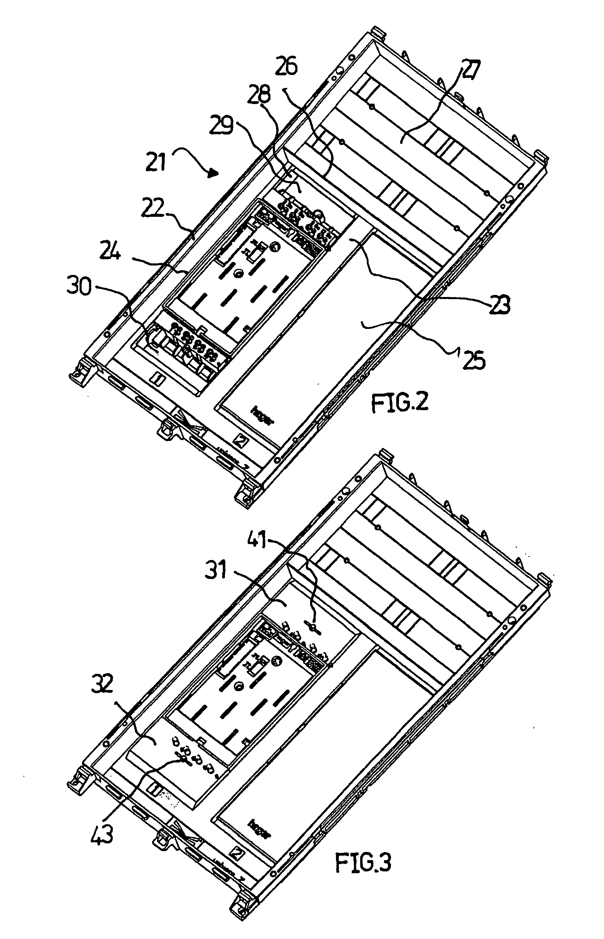

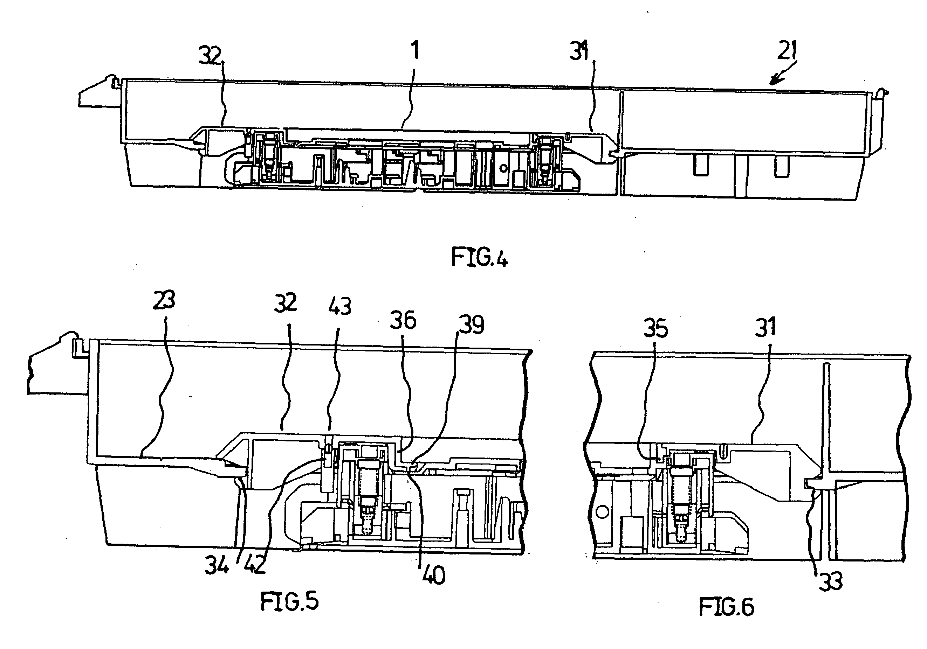

Wie die Figuren 2 bis 6 zeigen, lässt sich der vorangehend beschriebene Anschlussmodul 1 z.B. zusammen mit einer Aufnahmeeinrichtung 21 verwenden, die wannenartig mit einem umlaufenden Randsteg 22 und einer Bodenplatte 23 ausgebildet ist. In der Bodenplatte 23 sind durch je einen Deckel verschließbare Öffnungen 24 und 25 gebildet, in die jeweils ein Anschlussmodul 1 einsetzbar ist.

Eine Zwischenwand 26 trennt einen Raum 27 für die Unterbringung elektronischer Zusatzgeräte (nicht gezeigt) ab.

An den Längsrändern der Öffnungen 24 und 25 stehen auf der dem Randsteg 22 abgewandten Seite der Bodenplatte 23 Stege 28 mit Öffnungen (nicht sichtbar) für den Rasteingriff der Rastnasen 7 vor.

Wie Fig. 2 erkennen lässt, füllt der Anschlussmodul 1 die Öffnung 24 nicht vollständig aus. Am oberen und unteren Ende bleiben Öffnungsabschnitte 29 und 30 frei, welche freien Zugang zu den Anschlussleisten 5 und 6 und deren Schraubklemmanschlusselementen ermöglichen.

Die dem Anschlussmodul 1 abgewandten Randseiten der Deckel weisen Einbuchtungen 33 bzw. 34 auf, in welche der betreffende Öffnungsrand der Bodenplatte 23 eingreift. An den dem Anschlussmodul 1 zugewandten Randseiten ist jeweils eine Abwinklung 35 bzw. 36 für den Eingriff in die Rille 19 bzw. 37 gebildet. Seitliche Wangen an den Deckeln 31,32 nahe der Abwinklung 35 bzw. 36 weisen Einbuchtungen für den Rasteingriff der Nasen 20 bzw. 38 auf.

Etwa in der Mitte der Abwinklung 36 des Deckels 32 steht senkrecht zur Abwinklung eine Nase 39 mit einem Stützfuß 40 vor.

Bei der Installation eines Anschlussmoduls 1 in einem die Aufnahmeeinrichtung 21 aufweisenden Anschlussfeld wird der Anschlussmodul 1 nach Entnahme der betreffenden Deckel in eine der Öffnungen 24,25 eingeführt, bis die Rastnasen 7 in den genannten Öffnungen in den Stegen 28 einrasten.

Durch die Öffnungsabschnitte 29 und 30 hindurch sind an den Anschlussmodul 1 heran verlegte Anschlussleitungen zugänglich. Vom unteren Anschlussraum zugeführte Leitungen werden an der Anschlussleiste 5, in den oberen Anschlussraum führende Leitungen an der Anschlussleiste 6 angeschlossen.

Nach Abschluss der Anschlussarbeiten werden die Deckel 31 und 32 angebracht, wobei die Rastnasen 20,38 in den betreffenden Rastvertiefungen an den Deckeln einrasten.

Der Deckel 32, welcher den Zugang zu den ungezählten Strom führenden Leitungen versperrt, ist durch den angeschlossenen Stromzähler gesichert, indem die Nase 39 das Gehäuse des Stromzählers hintergreift. Der Deckel 32 wird auf diese Weise formschlüssig an der Bodenplatte 23 und dem Anschlussmodul 1 gehalten. Zusätzlich besteht die Möglichkeit, den Deckel 32 durch eine Schraube zu sichern, die durch eine Öffnung 45 in ein an der Anschlussleiste 5 gebildetes Innengewinde 42 einschraubbar und plombierbar ist.

Auch für den Deckel 31 besteht die Möglichkeit zu einer Sicherung durch eine plombierbare Schraube, die durch eine Öffnung 43 im Deckel 31 hindurch in ein dem Innengewinde 42 gegenüberliegendes Innengewinde 44 an der oberen Anschlussleiste 6 eindrehbar ist.

Der vorangehend beschriebene Anschlussmodul 1 ist nicht für den Standardstromwert von 63 A sondern für 100 A ausgelegt. Für den Fall, dass die verlegten Anschlussleitungen dieser Auslegung nicht entsprechen, hat der Installateur die Möglichkeit, das Schild 13 zu lösen und in umgekehrter Stellung am Gehäuse 2 des Anschlussmoduls 1 einzurasten. Die Rückseite zeigt den Standardwert 63 A.

Elektronische Zusatzgeräte in dem abgetrennten Raum 27 können zur Spannungsversorgung wahlweise mit der Anschlussleiste 5 oder der Anschlussleiste 6 verbunden werden, je nachdem ob die Zusatzgeräte vom Stromversorgungsunternehmen durch ungezählten oder vom Stromkunden durch gezählten Strom betrieben werden.

Der Anschlussmodul 1 lässt sich, wie bereits erwähnt, auch am Zählerkreuz eines herkömmlichen Zähleranschlussplatzes oder, im einfachsten Fall, auf einer Trägerplatte anbringen. In diesen Fällen, in denen der Anschlussmodul z.B. gemäß Fig. 7 auf einer Trägerplatte 45 befestigt wird, kommt eine Abdeckhaube 46 zum Einsatz, welche die durch eine Öffnung 48 in der Trägerplatte 45 hindurch zugeführten, ungezählten Strom führenden Anschlussleitungen abdeckt. Die Abdeckhaube 46 lässt sich in gleicher Weise wie der Deckel 32 in der Abdeckposition durch Formschluss oder/und eine plombierbare Schraube sichern. Fig. 7 zeigt ferner, wie der Anschlussmodul 1 durch Laschen 47 unter Eingriff in die Öffnungen 16 an der Tragplatte 45 befestigt ist.

## Patentansprüche

1. Anschlusssystem für einen elektronischen Stromzähler, mit einem Anschlussmodul (1), an den der Stromzähler in einer Aufsteck- und Verschiebebewegung elektrisch und mechanisch koppelbar ist und der ein Gehäuse (2) mit einer außenseitigen Tragfläche (3) für den Stromzähler aufweist, in der Öffnungen zur Einführung von dem Stromzähler in Aufsteckrichtung vorstehender Anschlusskontakte in das Gehäuse gebildet und wobei in dem Gehäuse Elemente zum lösbaren Anschluss Strom führender Leitungen untergebracht sind,
**dadurch gekennzeichnet,**
**dass** das Gehäuse (2) die Grundform einer rechteckigen Platte aufweist und dass an einer der schmalen Randseiten des Gehäuses (2) Elemente für den Anschluss ungezählten Strom führender Leitungen und an der anderen schmalen Randseite Elemente für den Anschluss gezählten Strom führender Leitungen angeordnet sind.

2. Anschlusssystem nach Anspruch 1,
**dadurch gekennzeichnet,**
**dass** auf beiden Randseiten ferner Elemente für den Anschluss von Spannungsversorgungsleitungen vorgesehen sind.

3. Anschlusssystem nach Anspruch 1 oder 2,
**dadurch gekennzeichnet,**
**dass** die Anschlusselemente Klemmanschlusselemente, insbesondere Schraubklemmelemente, sind.

4. Anschlusssystem nach einem der Ansprüche 1 bis 3,
**dadurch gekennzeichnet,**
**dass** die Anschlusselemente unter Bildung von Anschlussleisten (5,6) in zu den Randseiten parallelen Reihen angeordnet sind.

5. Anschlusssystem nach Anspruch 4,
**dadurch gekennzeichnet,**
**dass** die Länge der Anschlussleisten (5,6) </= der Länge der schmalen Randseiten ist.

6. Anschlusssystem nach einem der Ansprüche 1 bis 5,
**dadurch gekennzeichnet,**
**dass** auf gegenüberliegenden Randseiten, insbesondere Längsrandseiten, des Gehäuses (2) Rastnasen (7) zur Rastverbindung des Anschlussmoduls (1) mit einer den Anschlussmodul (1) tragenden Aufnahmeeinrichtung (21) vorgesehen sind.

7. Anschlusssystem nach einem der Ansprüche 1 bis 6,
**dadurch gekennzeichnet,**
**dass** das Gehäuse (2) Einrichtungen zur Befestigung des Anschlussmoduls (1) an einem Zählerkreuz aufweist.

8. Anschlusssystem nach Anspruch 7,
**dadurch gekennzeichnet,**
**dass** die Einrichtungen zur Befestigung des Anschlussmoduls an dem Zählerkreuz einen Durchgang (11) durch das Gehäuse (2) und zwei vom Gehäuse vorstehende Hakenelemente (9,10) umfassen.

9. Anschlusssystem nach einem der Ansprüche 6 bis 8,
**dadurch gekennzeichnet,**
**dass** die Aufnahmeeinrichtung (21) eine die anschließbaren Leitungen abdeckende Platte (23) aufweist, in der wenigstens eine Öffnung (24,25) gebildet ist, in die sich der Anschlussmodul (1) einsetzen lässt.

10. Anschlusssystem nach Anspruch 9,
**dadurch gekennzeichnet,**
**dass** die Rastnasen (7) in Öffnungen einrasten, die in Stegen (28) gebildet sind, die an einander gegenüberliegenden Rändern, insbesondere Längsrändern, der Öffnungen (24,25) von der Platte (23) vorstehen.

11. Anschlusssystem nach Anspruch 9 oder 10,
**dadurch gekennzeichnet,**
**dass** beim Einsetzen des Anschlussmoduls (1) in die Öffnung (24,25) freibleibende Abschnitte (29,30) der Öffnung (24,25) durch Deckel (31,32) verschließbar sind.

12. Anschlusssystem nach Anspruch 11,
**dadurch gekennzeichnet,**
**dass** die Deckel (31,32) zur Befestigung an der Aufnahmeeinrichtung (21) und dem Anschlussmodul (1) an dem Anschlussmodul (1) und/oder der Aufnahmeeinrichtung (21) einrastbar sind.

13. Anschlusssystem nach Anspruch 11 oder 12,
**dadurch gekennzeichnet,**
**dass** der Deckel (32) für die Randseite, an der die Anschlusselemente für die ungezählten Strom führenden Leitungen angeordnet sind, eine in der Anschlussposition des Stromzählers den Stromzähler hintergreifende Nase (39) aufweist.

14. Anschlusssystem nach einem der Ansprüche 11 bis 13,
**dadurch gekennzeichnet,**
**dass** Einrichtungen (41-44) für eine plombierbare Schraubbefestigung der Deckel (31,32) vorgesehen sind.

15. Anschlusssystem nach einem der Ansprüche 1 bis 14,
**dadurch gekennzeichnet,**
**dass** am Gehäuse (2) seitliche Öffnungen (16) für den Eingriff den Anschlussmodul (1) auf einer Trägerplatte (45) haltender Befestigungslaschen (47) vorgesehen sind.

16. Anschlusssystem nach einem der Ansprüche 1 bis 15,
**dadurch gekennzeichnet,**
**dass** ein um die Tragfläche (3) umlaufender Randsteg (17) gebildet ist.

17. Anschlusssystem nach Anspruch 16,
**dadurch gekennzeichnet,**
**dass** angrenzend an den Randsteg (17) Rillen (19,37) für den Eingriff an den Deckeln (31,32) gebildeter Abwinklungen (35,36) vorgesehen sind.

18. Anschlusssystem nach einem der Ansprüche 1 bis 17,
**dadurch gekennzeichnet,**
**dass** der Modul (1) ein abnehmbares und in umgekehrter Lage wieder an dem Anschlussmodul (1) anbringbares Anzeigeschild (13) aufweist.
